(19) Europäisches Patentamt
European Patent Office
Office européen des brevets

(11) **EP 2 220 191 B1**

(12) **EUROPÄISCHE PATENTSCHRIFT**

(45) Veröffentlichungstag und Bekanntmachung des Hinweises auf die Patenterteilung:
**28.03.2018   Patentblatt 2018/13**

(51) Int Cl.:
**H01L 33/50** (2010.01)   **C09K 11/77** (2006.01)

(21) Anmeldenummer: **08861047.2**

(22) Anmeldetag: **17.11.2008**

(86) Internationale Anmeldenummer:
**PCT/EP2008/065648**

(87) Internationale Veröffentlichungsnummer:
**WO 2009/077277 (25.06.2009 Gazette 2009/26)**

(54) **Wellenlängenkonvertierte LED**

Wavelength-converted LED

Diode électroluminescente convertie en longueur d'onde

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **14.12.2007   DE 102007060198**

(43) Veröffentlichungstag der Anmeldung:
**25.08.2010   Patentblatt 2010/34**

(73) Patentinhaber: **OSRAM GmbH**
**80807 München (DE)**

(72) Erfinder:
- **BERBEN, Dirk**
  **86399 Bobingen (DE)**
- **FIEDLER, Tim**
  **81369 München (DE)**
- **HIRRLE, Renate**
  **86163 Augsburg (DE)**

- **HUBER, Günter**
  **86529 Schrobenhausen (DE)**
- **JERMANN, Frank**
  **86343 Königsbrunn (DE)**
- **ZACHAU, Martin**
  **82269 Geltendorf (DE)**

(74) Vertreter: **Epping - Hermann - Fischer Patentanwaltsgesellschaft mbH Schloßschmidstraße 5 80639 München (DE)**

(56) Entgegenhaltungen:
**WO-A-2007/005486       WO-A-2007/020556
WO-A-2007/125493       US-A1- 2005 253 114
US-A1- 2006 027 781     US-B1- 6 255 670
US-B1- 6 466 135**

**Beschreibung**

Technisches Gebiet

Die Erfindung geht aus von einer Konversions-LED, häufig auch LUKOLED genannt, gemäß dem Oberbegriff des Anspruchs 1. Weiter betrifft die Erfindung eine damit hergestellte Lichtquelle bzw. ein Beleuchtungssystem mit einer derartigen Konversions-LED.

Stand der Technik

Die US-B 7 077 978 beschreibt einen Leuchtstoff auf der Basis von BAM, der mit Eu und Mn dotiert ist. Dieser Leuchtstoff ist für die Anwendung bei UV-LEDs gedacht. Ein ähnlicher Leuchtstoff ist aus WO 2006/072919 bekannt. Außerdem ist aus WO 2006/027786 ein rein mit Eu dotierter Leuchtstoff auf BAM-Basis bekannt. Die übliche Dotierung bei einem derartigen Leuchtstoff ist ein maximaler Gehalt von Eu2+ von höchstens 50 mol.-% des Ba. Ein BAM-Leuchtstoff mit einem Eu Anteil von bis zu 50 mol.-% ist aus WO 2007/005486 A2 bekannt. Ein SAM-Leuchtstoff mit einem Eu Anteil von bis zu 80 mol.-% ist aus US 2006/0027781 A1 bekannt.

Darstellung der Erfindung

Die Aufgabe der vorliegenden Erfindung ist es, eine Konversions-LED mit einer primären Lichtquelle im kurzwelligen Bereich anzugeben, die keine vorzeitige Alterung zeigt. Dabei soll die Peakwellenlänge der Anregung bei höchstens 420 nm liegen.
Diese Aufgabe wird gelöst durch die kennzeichnenden Merkmale des Anspruchs 1.
Besonders vorteilhafte Ausgestaltungen finden sich in den abhängigen Ansprüchen.
Die Konversions-LED umfasst eine primäre Lichtquelle, die UV-Strahlung emittiert. Erfindungsgemäß ist die Lichtquelle mindestens ein Chip, auf dessen Oberfläche ein neuartiger BAM-Leuchtstoff sitzt, wobei die Schichtdicke höchstens 50 $\mu$m, bevorzugt höchstens 30 $\mu$m, beträgt. insbesondere ist di Schichtdicke 5 bis 20 $\mu$m. Der neuartige Leuchtstoff absorbiert so effektiv, dass keine schädigende UV-Strahlung die Schicht verlässt.
Die bisher bekannten BAM-Leuchtstoffe haben typisch die Stöchiometrie BaMgAl10O17:Eu. Dabei ist Eu ein zweiwertiger Aktivator, der üblicherweise in einer maximalen Konzentration von allenfalls 50 % des Ba, gerechnet in MolProzent, zugegeben wird. Gelegentlich wird auch Mn als Ko-Aktivator verwendet, um die Emission langwelliger zumachen. Die Emission liegt somit im Blauen oder Blaugrünen Spektralbereich.
Insbesondere zur Realisierung effizienter weißer LEDs auf Basis von UV-LEDs sind effiziente, temperaturstabile blaue Leuchtstoffe notwendig. Dies setzt eine gute Absorption der Leuchtstoffe vor allem im Bereich 340-420 nm, insbesondere 380-410 nm bei near-UV-LEDs, sowie eine hohe Quanteneffizienz voraus. Die Leuchtstoffe dürfen bei hohen Anregungsintensitäten, wie sie insbesondere in Hochleistungs-LEDs vorkommen, nicht sättigen. Außerdem sollten sie aufgrund der hohen auftretenden Temperaturen bis zu 200 °C in Hochleistungs-LEDs eine möglichst geringe thermische Löschung der Lumineszenz aufweisen.
Zur Zeit werden dafür überwiegend SCAP:Eu (Sr,Ca-Chlorapatite) sowie BAM:Eu (BaMg-Aluminat) als blau emittierende Leuchtstoffe eingesetzt. SCAP weist bei den üblicherweise verwendeten Eu-Konzentrationen zwischen 5 und 15% Eu bereits eine sehr hohe Absorption im Spektralbereich zwischen 380 - 410 nm auf. Allerdings sind Quanteneffizienz und thermisches Lösch-Verhalten bei diesen Eu-Konzentrationen nicht mehr optimal und schlechter als bei BAM:Eu. Außerdem ist die kurzwellige, schmalbandige Emission von SCAP nicht immer von Vorteil, wenn effiziente weiße LED mit hoher Farbwiedergabe hergestellt werden sollen. BAM:Eu wird mit Eu-Konzentration < 50% (typisch eher < 30%) eingesetzt, hat aber gegenüber SCAP den Nachteil einer schlechteren Absorption im Bereich 380-410 nm.
Durch überwiegende Substitution des Ba2+ - Ions durch Eu2+ im BAM-Wirtsgitter BaMgAl10O17 ergibt sich überraschenderweise ein sehr effizienter Leuchtstoff. Dabei ist wichtig, dass der Ba-Gehalt so eingestellt wird, dass eine zu starke Energiemigration zwischen den Eu2+ - Ionen verhindert wird. Sehr gut geeignete Leuchtstoffe erhält man typischerweise für Ba-Konzentrationen zwischen 35 und 45%, gemäß der Formel $Ba_xEu_{1-x}MgAl_{10}O_{17}$ mit x = 0,35 bis 0,45.
Ein typisches Beipiel ist Eu0,6Ba0,4MgAl10O17. Der 40%-Anteil an Ba2+ unterbindet hier wirksam eine zu starke Energiemigration und damit thermische Lumineszenzmischung. Der neue Leuchtstoff ist beispielsweise für "Color on demand"-LEDs oder für weiße LEDs geeignet. Er lässt sich für unterschiedliche Farbtemperaturen und Anwendungen mit hoher Effizienz und guter Farbwiedergabe maßschneidern.
Der erfindungsgemäße Eu-Aluminat-Leuchtstoff weist eine extrem geringe Temperaturlöschung auf. Bei 175 °C liegt die Effizienz noch oberhalb von 80% der Effizienz bei 25°C. Die Pulvertabletten-Absorption der Verbindung Eu0,6Ba0,4MgAl10O17 liegt bei Anregung mit 400 nm bereits bei mehr als 80% und ist bei 380 nm sogar größer als 90% bei Partikelgrößen des Leuchtstoffs kleiner als 12 $\mu$m. Eine gut geeignete Partikelgröße ist 0,5 bis 10 $\mu$m. Der

Begriff Partikelgröße ist hier verstanden als d50-Wert, genauer als median der mittels Laserstreuung, beispielsweise CILAS, gemessenen, volumenbezogenen Partikelgrößenverteilung.

Die Quanteneffizienz (QE) des neuartigen Leuchtstoffs liegt typischerweise bei 84% +/- 5% bei Anregung mit 400 nm. Bei noch kürzerwelliger Anregung lassen sich QE-Werte von mehr als 90% erreichen.

Dabei wird bewusst darauf verzichtet, die häufig übliche Co-Dotierung mit Mn zu verwenden. Hier nimmt Mn den Gitterplatz von Mg ein. Ein derariger Leuchtstoff zeigt jedoch merklich schlechtere Eigenschaften als ein rein mit Eu dotierter Leuchtstoff. Das Ion Mn ist wesentlich emfindlicher gegenüber Sättigung.

Die hohe Europiumdotierung lässt sich auch auf BAM-Leuchtstoffe mit anderer Stöchiometrie und Zusammensetzung anwenden. In einer weiteren Ausführungsform wird der BAM-Leuchtstoff beschrieben durch die Stöchiometrie $Ba_xEu_{1-x}Mg_{1+d}Al_{10+2f}O_{17+d+3f}$.

Dabei gilt $0,2 \leq x \leq 0,48$; bevorzugt ist $0,35 \leq x \leq 0,45$;

$$0 \leq d \leq 0,1;$$

$$-0,1 \leq f \leq 1,0.$$

Es handelt sich dabei um mehr oder weniger stöchiometrisch einfach beschreibbare Verbindungen, wie diese Varietäten für BAM bekannt sind. Grundsätzlich sind solche Wirtsgitter beispielsweise aus WO 2006/072919 vorbekannt. In seiner allgemeinsten Form umfasst daher das Wirtsgitter BAM auch Stöchiometrien beispielsweise des Typs BaAl12O19 oder noch allgemeiner formuliert lässt sich die Vielzahl an Stöchiometrien für BAM so darstellen, dass es sich um eine Mischung zweier Aluminate handelt, wobei ein erstes Aluminat Ba-arm ist, entsprechend der Stöchiometrie $0,82BaO*6Al_2O_3$, und ein zweites Aluminat Mg-haltig ist und das eigentlich BAM BaMgAl10O17 repräsentiert. Weil das Ba-arme Aluminat und das eigentliche BAM BaMgAl10O17 dieselbe Kristallstruktur wie beta-Al2O3 haben, bilden beide Verbindungen feste Lösungen mit beta-Al2O3-Struktur. Eine allgemeine Aluminat-Stöchiometrie lässt sich daher beschreiben als $\{ (1-a)*(0,82[Ba_xEu_{1-x}O]*6[Al_2O_3]) \}*a(Ba_xEu_{1-x}MgAl_{10}O_{17})$. Dabei ist a grundsätzlich gegeben durch $0 \leq a \leq 1$. Bevorzugt ist a mindestens 0,65, besonders bevorzugt mindestens 0,8. Der Wert für x liegt bei mindestens 0,52, bis hin zu 0,8. Bevorzugt ist x = 0,55, bis 0,65.

Bei weniger belasteten Anwendungen kann auch Mn kodotiert werden als Ersatz für Mg gemäß der Aluminat-Stöchiometrie $\{(1-a)*(0,82[Ba_xEu_{1-x}O]*6[Al_2O_3])\}*a(Ba_xEu_{1-x}Mg_{1-z}Mn_zAl_{10}O_{17})$.

Dabei sollte z insbesondere höchstens 0,15 betragen, bevorzugt höchstens 0,04.

Des weiteren lässt sich Ba in dieser Darstellung teilweise durch Sr, oder auch teilweise durch Ca, substituieren.

In einer weiteren Ausführungsform lässt sich die hohe Europiumkonzentration auf Leuchtstoffe anwenden, bei denen Ba teilweise durch Sr und/oder Ca ersetzt ist, und die vom eigentlichen BAM abgeleitet sind. Dieser Leuchtstoff wird beschrieben durch die Stöchiometrie $M_xEu_{1-x}Mg_{1+d}Al_{10+2f}O_{17+d+3f}$ mit M = (Ba,Sr,Ca), wobei M durch $Ba_z(Ca,Sr)_{1-z}$ repräsentiert ist mit $z \geq 0,7$.

Dabei gilt $0,2 \leq x \leq 0,48$; bevorzugt ist $0,35 \leq x \leq 0,45$;

$$0 \leq d \leq 0,1;$$

$$-0,1 \leq f \leq 1,0.$$

In verallgemeinerter Form lassen sich auch Leuchtstoffe dieses Typs ähnlich wie in EP 529 956 beschreiben. Die allgemeine Formel ist $(M_{1-r}Mg_r)O*k\,Al2O3$, wobei r = 0,4 bis 0,6. Dabei gilt für das Metall M, dass es mit Euorpium dotiert ist, wobei $M = EA_eEu_{1-e}$, mit EA = Ba,Sr,Ca. für e gilt e = 0,52 bis 0,8, insbesondere e = 0,55 bis 0,65. Für k gilt k = 1,5 bis 4,5. Ein derartiger Leuchtstoff eignet sich insbesondere für die Mischung mit anderen Leuchtstoffen, gemäß beispielsweise dem RGB-Prinzip. Insbesondere eignet sich dabei eine Mischung des neuartigen BAM mit Zn2SiO4:Mn oder BaAl12O19:Mn für die grüne Komponente und mit (Y,Gd)BO3:Eu oder YOE, also Y2O3:Eu für die rote Komponente.

Die Herstellung derartiger Leuchtstoffe gelingt im Prinzip wie bei bekannten BAM-Leuchtstoffen. Als Schmelzmittel haben sich dabei Halogenverbindungen, bevorzugt Fluoride und Chloride, bewährt. Aber auch Lithium- und Bor-haltige Verbindungen lassen sich einsetzen.

Für die Herstellung werden die Edukte Al2O3, BaCO3, SrCO3, MgO, Eu2O3, BaF2 im Taumelmischer o.ä. für mehrere Stunden gemischt. Die Reaktionstemperatur sollte bei 1500 bis 1650 °C liegen. Danach wird Formiergas mit einem Anteil H2 von 2 bis 20 % eingeleitet. Anshcießend wird der Leuchtstoff in einer Mühle für etwa 5 bis 30 min gemahlen. Anschließend kann der Leuchtstoff ggf. noch Wasser oder verdünnten Säuren gewaschen werden.

Darüber hinaus lassen sich in dieses allgemeine Wirtsgitter auch in geringem Umfang die Elemente, F, Cl, Li, Na, B, La, Ce, Nd, Sm, Pr, Gd, Yb, Lu einsetzen. Dabei sollte die über XRD nachweisbare Gitterstruktur im wesentlichen unverändert bleiben. Im einzelnen lassen sich insbesondere folgende Modifikationen durchführen:

- Ersatz von Al in geringem Umfang durch B;

- Substitution von 2M durch M1+M3, wobei M1 eines oder mehrere der einwertigen Metalle Li und/oder Na ist und M3 eines oder mehrere der dreiwertigen Seltenerdmetalle aus der Gruppe La, Ce, Nd, Sm, PR, Gd. Yb, Lu ist;

- Einbau von M1+H in das Wirtsgitter, wobei M1 ein einwertiges Metall wie oben definiert ist und H eines oder mehrere Halogene aus der Gruppe F, Cl ist; bevorzugt liegt der Anteil bei maximal 1 %.

- Einbau auf Zwischengitterplätze von dreiwertigen Seltenerdmetallen M3 + ZZ, wobei M3 wie oben definiert ist und ZZ eines oder mehrere Elemente aus der Gruppe F, Cl, O ist; auch Mischungen daraus; bevorzugt liegt der Anteil für F und Cl bei maximal 1 %, für O bei maximal 5 %.

- Einbau von verschiedenen metallischen Ionen wie Si, die in großen Konzentrtionen die Lumineszenez quenchen würden, in einem Umfang, der die Luminesznez noch nicht merklich verringert. Damit sind Anteile in Spuren gemeint, die deutlich unter 1 Gew.% liegen.

Der erfindungsgemäße Leuchtstoff lässt sich bevorzugt für LEDs, die im UV emittieren anwenden, um eine Konversion in den sichtbaren Spektralbereich zu erzielen. Die Anregung gelingt am besten bei einer Peakwellenlänge von 300 bis 420 nm, bevorzugt 340 bis 410 nm, besonders bevorzugt bei 380 bis 410 nm. Als Lichtquellen eignen sich alle LEDs nach dem Prinzip einer Konversions-LED. Dabei lassen sich zum einen farbig emittierende LEDs realisieren, wobei insbesondere nur ein einziger Leuchtstoff des oben beschriebenen Aluminat-Typs, insbesondere BAM, verwendet wird. Dabei kann insbesondere eine blau emittierende LED mit großer FWHM realisiert werden, die die Basis für LEDs oder LED-Module mit hoher Farbwiedergabe bildet.

Es lassen sich aber auch andere LEDs realisieren, wobei dafür im allgemeinen auch zusätzlich mindestens ein weiterer Leuchtstoff, der entweder gelb emittiert (für eine "BY"-Lösung), oder grün und rot emittierende Leuchtstoffe (für eine "RGB"-Lösung), wie an sich bekannt verwendet werden. Damit lassen sich weiß emittierende LEDs mit besonders hoher Farbwiedergabe realsiieren. Der Ra ist mindestens 80, insbesondere mindestens 90.

Für eine BY-Lösung eignet sich insbesondere ein Granat wie YAG:Ce oder ein Sion als zusätzlicher Leuchtstoff. Für eine RGB-Lösung eignen sich insbesondere grüne Leuchtstoffe wie Nitridosilikate und rote Leuchtstoff wie Nitride als zusätzliche Leuchtstoffe.

Insbesondere lassen sich auch Mischungen aus verschiedenen Ausführungsformen des neuartigen Leuchtstoffs verwenden, beispielsweise blau und blaugrün emittierende Varietäten.

Kurze Beschreibung der Zeichnungen

Im Folgenden soll die Erfindung anhand eines Ausführungsbeispiels näher erläutert werden. Die Figuren zeigen:

Fig. 1     die Effizienz eines BAM-Leuchtstoffs bei Raumtemperatur als Funktion des Eu-Gehalts;

Fig. 2     die Effizienz des gleichen BAM-Leuchtstoff bei 175 °C als Funktion des Eu-Gehalts;

Fig. 3     die Emissionsintensität des gleichen BAM-Leuchtstoffs bei 400 nm Anregung als Funktion des Eu-Gehalts;

Fig. 4     die Quanteneffizienz des gleichen BAM-Leuchtstoffs als Funktion des Eu-Gehalts bei 400 nm Anregung;

Fig. 5     die Absorption des gleichen BAM-Leuchtstoffs bei 400 nm Anregung als Funktion des Eu-Gehalts;

Fig. 6     die Remission eines speziellen BAM-Leuchtstoffs als Funktion der Wellenlänge;

Fig. 7     die Emission des gleichen Leuchtstoffs als Funktion der Wellenlänge;

Fig. 8     das Löschungs-Verhalten (Quenching) des gleichen Leuchtstoffs als Funktion der Temperatur;

Fig. 9        das Emissionsverhalten eines modifizierten BAM-Leuchtstoffs beim Einbau von Mn;

Figur        10 das Emissionsverhalten verschiedener Leuchtstoffe mit unterschiedlicher Stöchiometrie;

Figur 11     den prinzipiellen Aufbau einer Lichtquelle für blaues Licht;

Figur 12     den prinzipiellen Aufbau einer Lichtquelle für weißes Licht;

Figur 13     Vergleich des Emissionsspektrums zweier LEDs.

Bevorzugte Ausführung der Erfindung

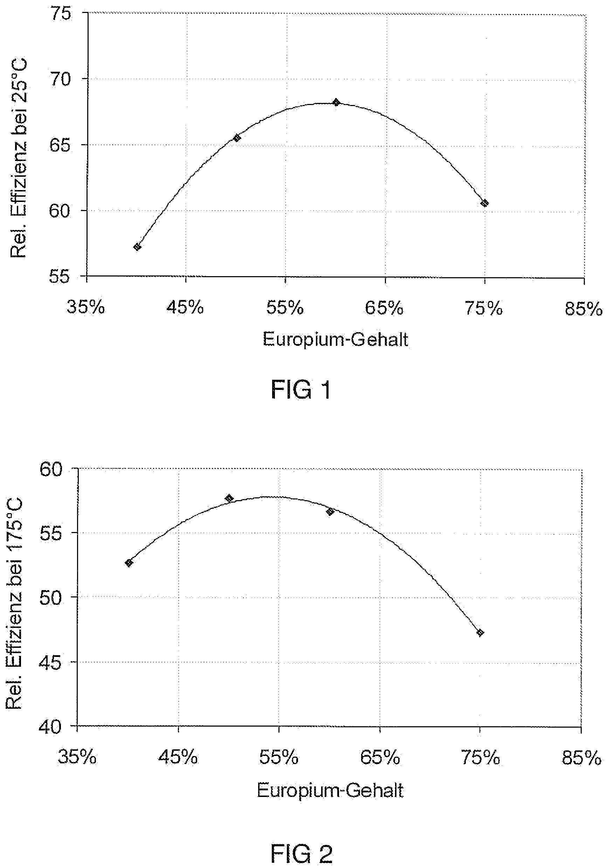

Figur 1 zeigt die relative Effizienz eines BAM-Leuchtstoffs $Ba_xEu_{1-x}MgAl_{10}O_{17}$ als Funktion des Eu-Gehalts in Mol.-%, bezogen auf M = (Ba,Eu). Es zeigt sich, dass die optimale Eu-Konzentration bei Raumtemperatur (25 °C) bei etwa 60 % Eu liegt, entsprechend einem Wert x = 0,4.

Die gleiche Messung, bezogen auf eine Temperatur von 175 °C ist in Figur 2 dargestellt. Sie liefert das Ergebnis, dass hier die optimale Eu-Konzentration bei etwa 54% liegt, entsprechend einem Wert x = 0,46.

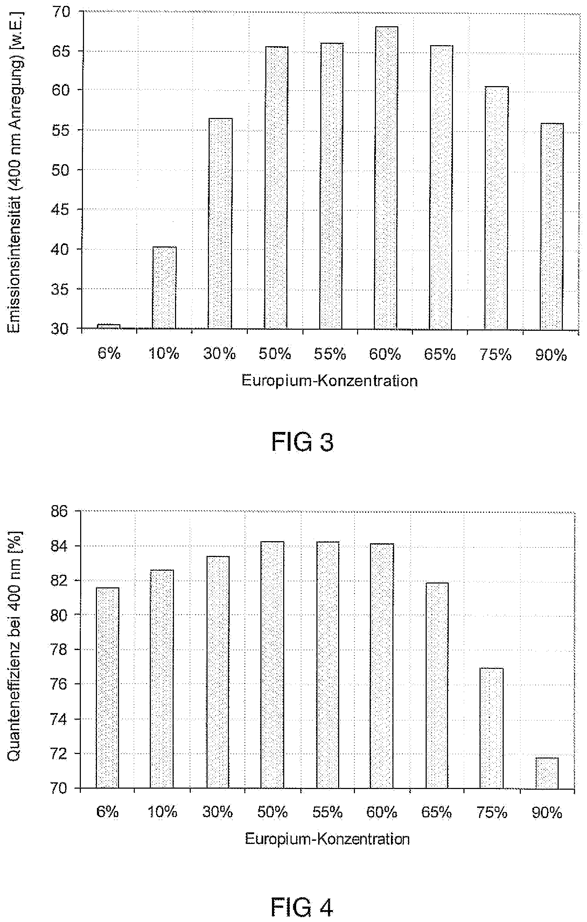

In Figur 3 ist die Emissionsintensität dieses Leuchtstoffs als Funktion der Eu-Konzentration bei Anregung mit 400 nm gezeigt. Überraschenderweise erreicht die Intensität ihr Maximum erst bei einer Eu-Konzentration von etwa 60 %, was wieder einem Wert x = 0,4 entspricht.

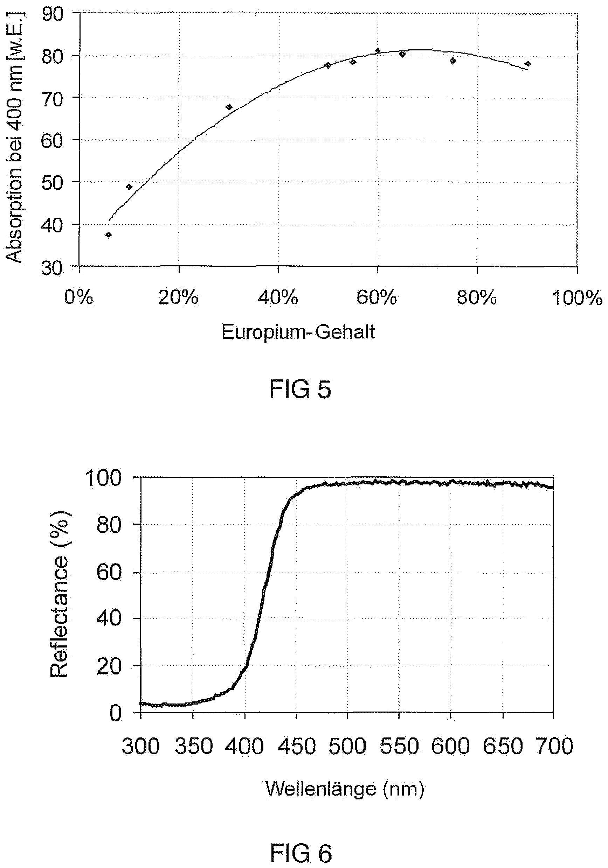

In Figur 4 ist die Quanteneffizienz als Funktion der Eu-Konzentration gezeigt. Überraschenderweise steigt die Quanteneffizienz bei relativ langwelliger Anregung, hier beispielhaft bei 400 nm, mit zunemhndem Eu-Gehalt zunächst an. Ein Optimum zeigt sich bei Werten für Eu im Bereich 50 bis 60 %, also einem x = 0,4 bis 0,5. Figur 5 zeigt die Absorption dieses BAM-Leuchtstoffs, bezogen auf eine Pulvertablette. Es zeigt sich, dass der neuartige Leuchtstoff eine gegenüber bisher üblichen BAM:Eu-Leuchtstoffen erheblich bessere Absorption aufweist.

Wesentlich für gute Eigenschaften einer Konversions-LED ist das Produkt aus QE und A.

Figur 6 zeigt die Remission des Leuchtstoffs $Eu_{0,6} Ba_{0,4} MgAl_{10}O_{17}$ in einer Pulvertablette vorliegend. Es zeigt sich, dass dieser Leuchtstoff eine gegenüber bisherigen Leuchtstoffen erheblich verbesserte Reflektanz aufweist. Dies gilt insbesondere für die Absorption.

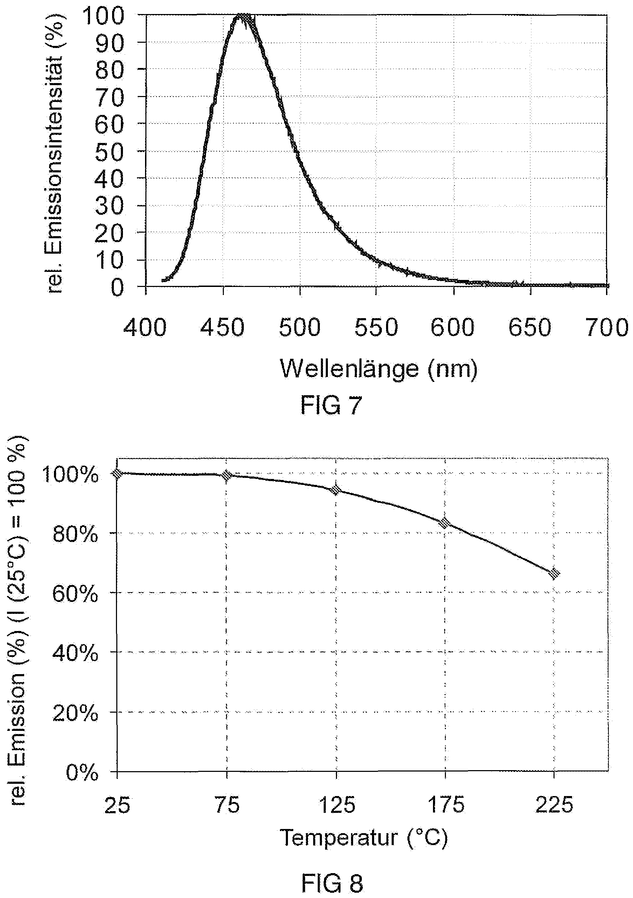

Figur 7 zeigt die Emission dieses konkreten Leuchtstoffs als Funktion der Wellenlänge. Es zeigt sich, dass das Emissionsverhalten sehr gut für LEDs mit hoher Farbwiedergabe geeignet ist. Die Emission ist relativ langwellig und hat einen hohen Blau-Grün-Anteil. Die Anregung ist auch hier mit 400 nm erfolgt.

Figur 8 zeigt das Lösungsverhalten dieses konkreten Leuchtstoffs als Funktion der Temperatur. Er ist sehr stabil, so dass bei 175°C die Effizienz immer noch mehr als 80 % der Effizienz bei 25 °C beträgt. Dies macht den neuen Leuchtstoff besonders für temperaturbelastete Umgebungen, beispielsweise in einer LED für Fahrzeugscheinwerfer, attraktiv.

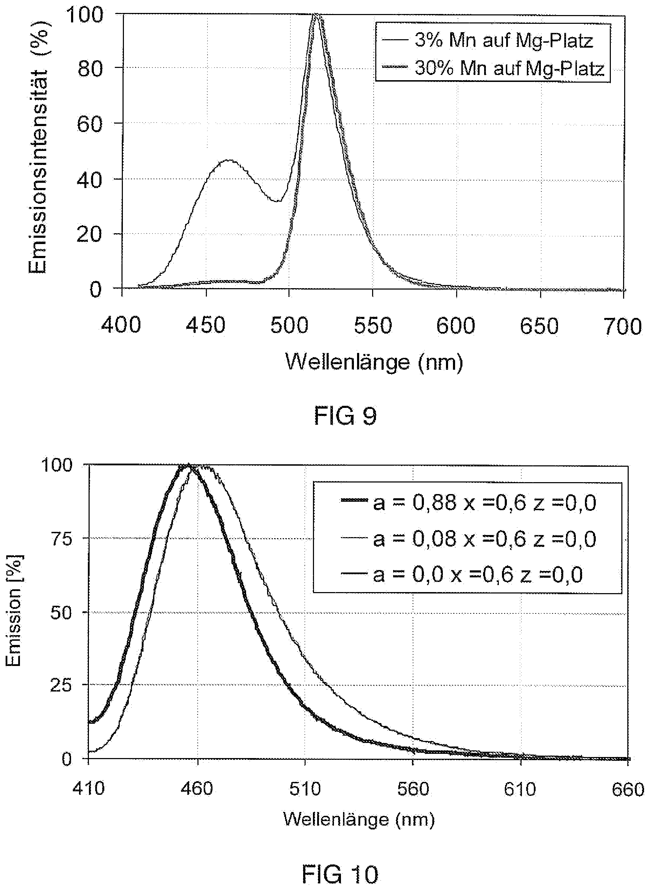

Figur 9 zeigt das Emissionsverhalten eines Leuchtstoffs mit der Stöchiometrie Ba0,4Eu0,6Mg1-yMnyAl10O17. Der Einbau von Mn auf Mg-Gitterplätze ermöglicht die Realisierung eines hocheffizienten, schmalbandigen Grünleuchtstoffs, der sich für wenig temperaturbelastete Umgebungen eignet, ideal beispielsweise für die LCD-Hinterleuchtung.

Figur 10 zeigt einen Vergleich der Emission verschiedener Mischungen aus einer Ba-armen Aluminatphase und der eigentlichen BAM-Phase. Der Mischungsparameter ist a, wie oben beschrieben. Bei geringer Aluminat-Konzentration, a = 0,08, wird keine signifikante Änderungen gegenüber der reinen BAM-Phase, also a = 0, beobachtet. Beide Kurven liegen praktisch übereinander. Bei hoher Aluminat-Konzentration a ergibt sich eine kurzwellige Verschiebung der Emission. Im gezeigten Ausführungsbeispiel ist a = 0,88. Dabei ist jeweils die Eu-Konzentration x, als Anteil am Metall M = $(Ba_{1-x},Eu_x)$ verstanden, 60 %. Dabei wird kein Mn als Co-Dotierung verwendet (z = 0). Dieser Mischungseffekt kann zur optimalen Einstellung der Emissionswellenlänge bzw. ihres Peaks in einer LED genutzt werden.

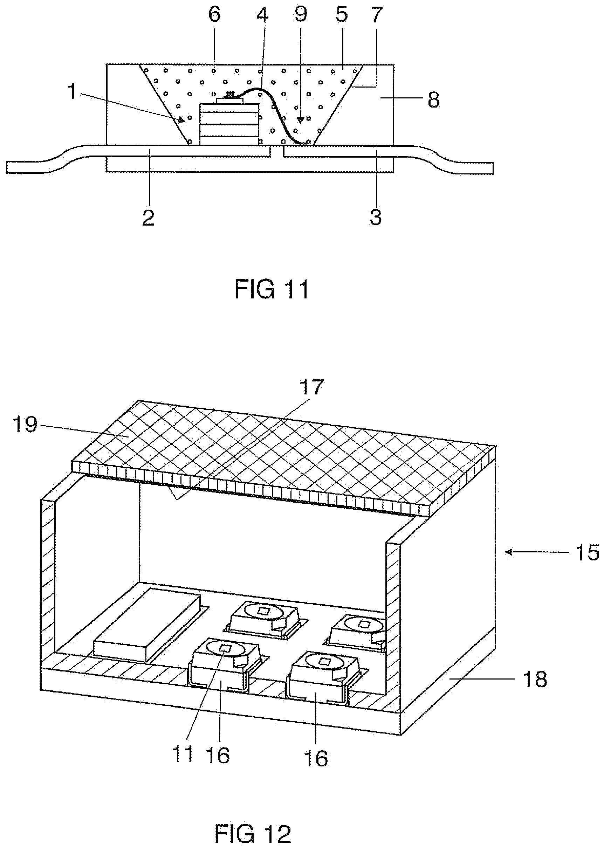

Figur 11 zeigt den prinzipiellen Aufbau einer Konversions-LED, auch LUKOLED, genannt, mit dem erfindungsgemäßen Leuchtstoff. Der Aufbau einer Lichtquelle für blaugrünes Licht ist in Figur 11 explizit gezeigt. Die Lichtquelle ist ein Halbleiterbauelement mit einem Chip 1 des Typs InGaN mit einer Peakemissionswellenlänge im UV von beispielsweise 405 nm, das in ein lichtundurchlässiges Grundgehäuse 8 im Bereich einer Ausnehmung 9 eingebettet ist. Der Chip 1 ist über einen Bonddraht 4 mit einem ersten Anschluss 3 und direkt mit einem zweiten elektrischen Anschluss 2 verbunden. Auf dem Chip ist direkt eine dünne Schicht 50 des neuartigen BAM aufgebracht. Bevorzugt wird dazu Elektorphorese verwendet, um die optimale geringe Schichtdicke zwischen 5 und 30 $\mu$m zu erreichen. Auch andere Techniken, wie sie im Stand der Technik beschrieben sind, kommen dafür in Frage. Wichtig ist, dass der Anteil anderer Sotffe möglichst gering ist, beispielsweise Binder.

Die Ausnehmung 9 ist mit einer Vergussmasse 5 gefüllt, die als Hauptbestandteile ein Silikonharz (80 bis 90 Gew.-%) und andere Leuchtstoffpigmente 6 (typisch weniger als 20 Gew.-%) enthält. Dabei handelt es sich um einen gelb emittierenden Leuchtstoff wie insbesondere YAG:Ce. Die Ausnehmung hat eine Wand 7, die als Reflektor für die Primär- und Sekundärstrahlung vom Chip 1 bzw. den Pigmenten 6 dient. Die Primärstrahlung der UV-LED wird vollständig vom Leuchtstoff in blaue Strahlung konvertiert. Der verwendete blau emittierende, dünn aufgetragene Leuchtstoff ist das oben beschriebene BAM:Eu (60 %).

Analog lässt sich mit einem derartigen Leuchtstoff auch eine Lichtquelle für weißes Licht realisieren, indem beispielsweise drei Leuchtstoffe verwendet werden, die von der UV-Strahlungsquelle angeregt werden, rot, grün und blau zu emittieren. Der grüne Leuchtstoff ist beispielsweise ein Ba-Sion, der rote ist beispielsweise Ca5Al4Si8N18:Eu oder ein Nitridosilikat (Ca,Sr)2Si5N8:Eu und der blaue, der direkt auf den Chip aufgetragen ist, ist ein Aluminat-Leuchtstoff wie BAM:Eu mit x = 0,4.

Der Aufbau einer anderen Lichtquelle für weißes Licht ist in Figur 12 explizit gezeigt. Die Lichtquelle, ist ein Halbleiterbauelement 16 vom Typ LED mit einem UV emittierenden Chip 11 des Typs InGaN mit einer Peakemissionswellenlänge von 380 nm. Auf dem Chip 11 ist eine dünne 20 $\mu$m dicke Schicht aus hoch Europium-haltigen BAM, insbesondere BAM:Eu(60%), aufgebracht (nicht dargestellt). Das Halbleiterbauelement 16 hat ein lichtundurchlässiges Grundgehäuse 18 mit Seitenwand 15 und Fenster 19 eingebettet. Die Konversions-LED 16 ist die Lichtquelle für weitere Leuchtstoffe, die in einer Schicht 14 auf dem Fenster 19 aufgetragen sind. Der weitere Leuchtstoff, der die Strahlung des Chips 13 teilweise konvertiert, ist ein gelber Leuchtstoff wie beispielsweise YAG:Ce, der die primäre Strahlung des Chips 13 teilweise konvertiert und in gelbe Strahlung der Peakemission 560 nm umwandelt.

In einem anderen Ausführungsbeispiel wird als primäre Lichtquelle eine UV-LED (etwa 380 nm) für eine weiße RGB-Lumineszenzkonversions-LED verwendet, wobei hier Probleme mit Alterung und Degradation von Gehäuse und Harz bzw. weiterer Leuchtstoffe nicht auftreten, weil der hochstabile BAM-Leuchtstoff direkt auf der Oberfläche des Chips aufgetragen ist. Damit ist die Einhaltung sonst üblicher Maßnahmen nicht mehr nötig, wie sorgfältige Wahl des Gehäusematerials, Zugabe UV-resistenter Harzkomponenten. Der große Vorteil dieser Lösung ist außerdem die geringe Blickwinkelabhängigkeit der Emissionsfarbe und die hohe Farbstabilität.

Als Lichtquelle für ein Beleuchtungssystem eignet sich bevorzugt eine Konversions-LED, insbesondere auf Basis von InGaN, oder ein Beleuchtungsmodul, insbesondere auf Basis einer LED.

Der Clou der vorliegenden Erfindung ist, dass der UV-LED-Chip mit einer hochkompakten Schicht stark UVabsorbierenden Leuchtstoffs beschichtet wird, der erstmals mit dem erfindungsgemäßen BAM:Eu zu Verfügung steht. Dabei ist die Schicht kleiner als 30 $\mu$m bevorzugt gewählt, und mindestens so dick, dass sie im wesentlichen die UV-Strahlung des Chips absorbiert, so dass keine Schädigung des Gehäuses und Harzes etc. mehr zu befürchten ist. der Volumenanteil des Leuchtstoffs in der kompakten Schicht wird dabei zu mindestens 50 % gewählt, bevorzugt mindestens 70%. Insbesondere eignet sich dafür eine elektrophoretsich abgeschiedene Schicht. Diese hochkompajkte Schicht enthält somit nur wenig alterungsanfälligers Material. Die Alterung des BAM-Leuchtstoffs, oder auch BAL-Leuchtstoffs, ist in diesem Zusammenhang vernachlässigbar. Die Schith ist also weitgehend alterungsbeständig.

Konvnetionelle beschcichtungsverfahren, wei beispielsweise Siebdruck sind bei derart hohen Volumenanteilen des Leuchtstoffs nicht mehr verarbeitbar. Die hohe Viksosität einer Leuchtstoff-Paste mit derart hohem FeststoffAnteil, bedingt durch den Leuchtstoff, verhindert die konvnetionelle Verarbeitung. Durch diese Anordnung wird eine vorzetige Alterung der Vergussmasse oder des Package-Amterials vermieden. Es wird die volle Lcihtleistung über die Lebensdauer erzielt.

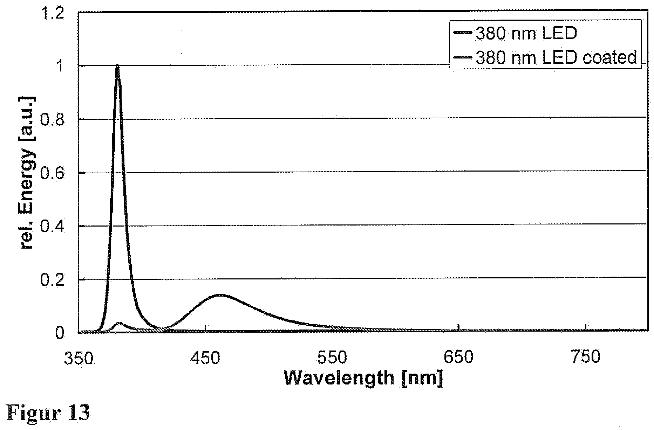

Voll-Konzentrations-LED benötigen in der Regel sehr hohe Leuchtstoff-Konzentrationen, welche detulcihe Lichtverluste bedingen. Diese Verluste können durch stark absorbierende und damit wenig streuende Leuchtstoffe jetzt erstmals gemindert werden. Nur der neuartige BAM:Eu- Leuchtstoff erlaubt durch seine drastisch erhöhte near-UV-Absorption, vor allem im Bereich 360 bis 400 nm aufgrudn des hohen Aktivatorsgehalts an Eu, in Verbindung mit einer blauen Emission, den Bau einer Vollkonversions-LED zu beleuchtungszwecken. Der große Vorteil liegt in der hohen Effizienz der Konversion sowie dem Schutz des Packages vor schädigender UV-Strahlung. Durch den geringen Anteil an Vergussmasse in der konvertierenden Leuchtstoff-Schicht und der geringen UV-Intensität außerhalb der konvertiernden Schicht ist die gesamte LED wesentlich weniger anfällig für UV-Bedingte Materialalterung. Konkret ist in Figur 13 eine 380 nm LED (Primäremmision Peak) dargestellt (relative Energie, spektral aufgetragen), die mit dem erfindungsgemäßen Leuchtstoff BAM:Eu(60 %) beschichtet ist, die Schichtdicke ist 10 $\mu$m. Die beiden Emissionsspektren einer unbeschichteten, klar vergosseenn LED (1) und einer beschcihtetetn , klar vergossenen LED (2) sind in Figur 13 dargestellt. Numerisch ergibt sich eine energetische Konversionseffizienz von summarisch 100 % für die ungecoatete LED (per Definitionem) gegenüber 78% bei der gecoateten Version.

Die so erzeugte LED lässt sich wie eine konventionelle blaue LED mit deutlich verbesserten Eigenschaften betrachten. Die emision verfügt über einen starken blaugrün-Anteil, der in einer konventionelllen LED praktisch vollständig fehlt. Hievon profitiert besonders die Farbwiedergabe der neuartigen LED. Neben der reinen Konversion in blau sind, wie oben dargestellt selbstversädnlich auch alle andern Konversions-LEDs realisierbar, insbesondere weiße LED auf Basis einer derartigen neuartigen blauen LED. Eine Möglichkeit ist die Beschichtung mit YAG:Ce oder mit YAGaG:Ce. Diese Leuchtstoffe weisen eine ausgeprägte aBsorptionslücke um 395 nm (bei YAG:Ce) bzw. 380 nm (Bei YAGaG:Ce) auf. Ähnliches gilt für andere bekannte Granat-Leuchtstoffe, die mit Ce dotiert sind. Daher wird es möglich, auf die erfindungsgemäße BAM:Eu-Schicht auf der LED eine gelbe Granat-Schicht aufzubringen, die das restliche transittierte UV-Strahlung in die BAM:Eu-Schicht zurückreflektiert. Danit kann diese BAM:Eu oder auch BAL:Eu-Schicht dünner sein. Dieser Leuchtstoff erhält also eine zusätzliche Möglcihket, das UV-Strahlung zu absorbieren. Andere Leuchtstoffe zur Erzeugung gelben bzw. roten Lichts können oft direkt mit UV-Strahlung gepumpt werden, auch hier kann aber die BAM:Eu-Schicht dünner sein, ohne das Package ddruch zu belasten. Mischungen aus BAM:Eu mit anderen Leuchtstoffen sind ebenfalls möglich. Dabei msus gewähleistet sein, dass die Shcith die nötige Kompaktheit beibehält.

Eine besonders wertvolle Eigenschaft des neuartigen Leuchtstoffs ist sein breite fWHM, die jetzt etwa 55 bis 65 nm beträgt. bEi Verwendung einer blauen LED (InGaN) ist diese FWHM typisch nur 10 bis 20 nm, was die Farbwiedergabe einer darauf basierenden weißen LED deutlich schlechter macht als wenn eine weiße LED auf der neuartigen blauen LED mit dirketer Konversin der UV-PrimärEmission durch die BAM:Eu-Schicht basiert. Hinzu kommt, dass die Stromfestigkeit und Temperatur-Festigkeit sowie die Wellenlängenshift bei der neuartigen LED erheblich besser sind als bei direkt emitiernend blauen LEDs.

## Patentansprüche

1. Konversions-LED mit einer primären Lichtquelle, die im kurzwelligen Strahlungsbereich unterhalb 420 nm emittiert und einem davor geschalteten Leuchtstoff aus dem BAM-System als Wirtsgitter zur mindestens teilweisen Konversion der Strahlung der Lichtquelle in längerwellige Strahlung **dadurch gekennzeichnet, dass** direkt auf der Oberfläche der Lichtquelle der BAM-Leuchtstoff als dünne Schicht mit einer Schichtdicke von höchstens 50 $\mu$m aufgetragen ist, wobei der BAM-Leuchtstoff die allgemeine Stöchiometric $(M_{1-r}Mg_r)O*k(Al_2O_3)$ besitzt, wobei r = 0,4 bis 0,6, und wobei M = $EA_eEu_{1-e}$, mit EA = Ba,Sr,Ca, wobei für k, k = 1,5 bis 4,5 gilt, **dadurch gekennzeichnet, dass** für e, e = 0,2 bis 0,48 gilt, insbesondere e = 0,35 bis 0,45, und, wobei bei EA = Ba allein verwendet wird oder teilweise ersetzt ist durch Sr und/oder Ca gemäß der Formel $Ba_z(Ca,Sr)_{1-z}$ mit z $\geq$ 0,7.

2. Konversions-LED nach Anspruch 1, **dadurch gekennzeichnet, dass** der BAM-Leuchtstoff die Stöchiometrie $M_xEu_{1-x}Mg_{1+d}Al_{10+2f}O_{17+d+3f}$, besitzt, mit 0,2 $\leq$ x $\leq$ 0,48; bevorzugt ist 0,35 $\leq$ x $\leq$ 0,45;

$$0 \leq d \leq 0,1;$$

$$-0,1 \leq f \leq 1,0.$$

3. Konversions-LED nach Anspruch 1, **dadurch gekennzeichnet, dass** die Stöchiometrie $Ba_xEu_{1-x}MgAl_{10}O_{17}$, ist wobei für x gilt: 0,35 $\leq$ x $\leq$ 0,45.

4. Konversions-LED nach Anspruch 1, **dadurch gekennzeichnet, dass** die Stöchiometrie $Ba_xEu_{1-x}MgAl_{10}O_{17}$, ist, wobei x im Bereich x = 0,35 bis 0,45 angesetzt ist.

5. Konversions-LED nach Anspruch 1, **dadurch gekennzeichnet, dass** die Stöchiometrie $Ba_xEu_{1-x}Mg_{1+d}Al_{10+2f}O_{17+d+3f}$, ist, wobei gilt:

0,2 $\leq$ x $\leq$ 0,48; bevorzugt ist 0,35 $\leq$ x $\leq$ 0,45;

$$0 \leq d \leq 0,1;$$

$$-0,1 \leq f \leq 1,0.$$

6. Konversions-LED gemäß einem der vorhergehenden Ansprüche zur Konversion von Primärstrahlung, wobei die Peakwellenlänge der Primärstrahlung im Bereich 300 bis 420 nm, bevorzugt 340 bis 410 nm liegt.

7. Konversions-LED nach Anspruch 1, **dadurch gekennzeichnet, dass** der Leuchtstoff die folgende Stöchiometrie aufweist: $\{(1-a)*(0,82[Ba_xEu_{1-x}O]*6[Al_2O_3])\}*a(Ba_xEu_{1-x}MgAl_{10}O_{17})$, wobei a grundsätzlich gegeben ist durch 0 $\leq$ a $\leq$ 1, insbesondere ist a mindestens 0,2, besonders bevorzugt mindestens 0,8, wobei der Wert für x bei mindestens 0,52, bis hin zu 0,8 liegt, und insbesondere ist x = 0,55, bis 0,65.

8. Konversions-LED nach einem der vorhergehenden Ansprüche, wobei Mn als Ko-Dotierung verwendet wird.

9. Beleuchtungssystem mit einer Konversions-LED gemäß einem der vorhergehenden Ansprüche, **dadurch gekennzeichnet, dass** die Lichtquelle primäre Strahlung mit einer Peakwellenlänge im Bereich 300 bis 420 nm emittiert und dass ein zur Konversion eingesetzter Leuchtstoff ein Aluminat des Wirtsgitter-Typs BAM ist, das mit Eu und evtl. zusätzlich mit Mn dotiert ist, wobei das Aluminat die Stöchiometrie aufweist: $M_xEu_{1-x}Mg_{1-y}+_dMn_yAl_{10+2f}O_{17+d+3f}$, wobei gilt

$0,2 \leq x \leq 0,48$; bevorzugt ist $0,35 \leq x \leq 0,45$;

$0 \leq y \leq 0,3$, bevorzugt $0 \leq y \leq 0,2$;

$$0 \leq d \leq 0,1;$$

$$-0,1 \leq f \leq 1,0$$

und wobei M = Ba allein öder teilweise ersetzt durch Sr und/oder Ca gemäß der Formel $Ba_z(Ca,Sr)_{1-z}$ mit $z \geq 0,7$.

10. Beleuchtungssystem nach Anspruch 9, **dadurch gekennzeichnet, dass** die Lichtquelle eine LED ist, insbesondere auf Basis von InGaN.

11. Beleuchtungssystem nach Anspruch 9, **dadurch gekennzeichnet, dass** die Lichtquelle ein Bcleuchtungsmodul mit einer LED ist, insbesondere auf Basis von InGaN.

## Claims

1. Conversion LED with a primary light source, which emits in the short-wave radiation range below 420 nm, and a luminophore of the BAM system placed in front of it as host lattice for at least partial conversion of the radiation of the light source into longer-wave radiation, **characterized in that**, directly on the surface of the light source, the BAM luminophore is applied as a thin layer with a layer thickness of at most 50 $\mu$m, wherein the BAM luminophore has the general stoichiometry $(M_{1-r}Mg_r)O*k(Al_2O_3)$, with r = 0.4 to 0.6 and M = $EA_eEu_{1-e}$, with EA = Ba,Sr,Ca, wherein for k, k = 1.5 to 4.5 applies, **characterized in that** for e, e = 0.2 to 0.48 applies, in particular e = 0.35 to 0.45, and wherein in EA = Ba is used alone or is partially replaced through Sr and/or Ca according to the formula $Ba_z(Ca,Sr)_{1-z}$, with $z \geq 0.7$.

2. Conversion LED according to claim 1, **characterized in that** the BAM luminophore has the stoichiometry $M_xEu_{1-x}Mg_{1+d}Al_{10+2f}O_{17+d+3f}$, with $0.2 \leq x \leq 0.48$, $0.35 \leq x \leq 0.45$ is preferred;

$$0 \leq d \leq 0.1;$$

$$-0.1 \leq f \leq 1.0.$$

3. Conversion LED according to claim 1, **characterized in that** the stoichiometry is $Ba_xEu_{1-x}MgAl_{10}O_{17}$, wherein $0.35 \leq x \leq 0.45$ applies for x.

4. Conversion LED according to claim 1, **characterized in that** the stoichiometry is $Ba_xEu_{1-x}MgAl_{10}O_{17}$, wherein x is set in the range x = 0.35 to 0.45.

5. Conversion LED according to claim 1, **characterized in that** the stoichiometry is $Ba_xEu_{1-x}Mg_{1+d}Al_{10+2f}O_{17+d+3f}$, wherein it applies:

$0.2 \leq x \leq 0.48$; $0.35 \leq x \leq 0.45$ is preferred;

$$0 \leq d \leq 0.1;$$

$$-0.1 \leq f \leq 1.0.$$

6. Conversion LED according to one of the preceding claims for the conversion of primary radiation, wherein the peak wave length of the primary radiation lies in the range of 300 to 420 nm, preferably 340 to 410 nm.

7. Conversion LED according to claim 1, **characterized in that** the luminophore has the following stoichiometry: $\{(1-a)*(0.82[Ba_xEu_{1-x}O]*6[Al_2O_3])\}*a(Ba_xEu_{1-x}MgAl_{10}O_{17})$, wherein a is generally provided through $0 \leq a \leq 1$, in particular a is at least 0.2, particularly preferably at least 0.8, wherein the value for x lies at at least 0.52, lies up to 0.8, and in particular x = 0.55 to 0.65

8. Conversion LED according to one of the preceding claims, wherein Mn is used as co-doping.

9. Illumination system with a conversion LED according to one of the preceding claims, **characterized in that** the light source emits primary radiation with a peak wave length in the range from 300 to 420 nm, and **in that** an luminophore employed for conversion is an aluminate of the BAM host lattice type, which is doped with Eu and possibly in addition with Mn, wherein the aluminate has the stoichiometry:

$$M_xEu_{1-x}Mg_{1-y+d}Mn_yAl_{10+2f}0_{17+d+3f},$$

wherein
$0.2 \leq x \leq 0.48$ applies; $0.35 \leq x \leq 0.45$ is preferred;
$0 \leq y \leq 0.3$, preferably $0 \leq y \leq 0.2$;

$$0 \leq d \leq 0.1;$$

$$-0.1 \leq f \leq 1.0$$

and wherein M = Ba alone or partially replaced through Sr and/or Ca according to the formula $Ba_z(Ca,Sr)_{1-z}$, with $z \geq 0.7$.

10. Illumination system according to claim 9, **characterized in that** the light source is an LED, in particular on the basis of InGaN.

11. Illumination system according to claim 9, **characterized in that** the light source is an illumination model with an LED, in particular on the basis of InGaN.


**Revendications**

1. LED de conversion comprenant une source de lumière primaire qui émet dans le domaine de rayonnement à ondes courtes situé en dessous de 420 nm, et comprenant un matériau fluorescent, installé en amont, provenant du système BAM, en tant que grille hôte pour la conversion au moins partielle du rayonnement de la source de lumière en rayonnement à ondes plus longues, **caractérisée en ce que** le matériau fluorescent BAM est appliqué directement sur la surface de la source de lumière en tant que couche mince ayant une épaisseur de couche de maximum 50 $\mu$m, le matériau fluorescent BAM possédant la stoechiométrie générale
$(M_{1-r}Mg_r)O*k(Al_2O_3)$
où r = 0, 4 à 0, 6, et M = $EA_eEu_{1-e}$ avec EA = Ba, Sr, Ca, pour k, on a k = 1,5 à 4,5, **caractérisée** ce que pour e, on a e = 0,2 à 0,48, notamment e = 0,35 à 0,45, et où EA = Ba est utilisé seul ou est partiellement remplacé par Sr et/ou Ca selon la formule $Ba_z(Ca,Sr)_{1-z}$, avec $z \geq 0,7$.

2. LED de conversion selon la revendication 1, **caractérisée en ce que** le matériau fluorescent BAM possède la

stoechiométrie $M_xEu_{1-x}Mg_{1+d}Al_{10+2f}O_{17+d+3f}$,
où l'on a
$0{,}2 \leq x \leq 0{,}48$ ; de préférence $0{,}35 \leq x \leq 0{,}45$ ;

$$0 \leq d \leq 0{,}1 \; ;$$

$$-0{,}1 \leq f \leq 1{,}0.$$

3. LED de conversion selon la revendication 1, **caractérisée en ce que** la stoechiométrie est $Ba_xEu_{1-x}MgAl_{10}O_{17}$, où l'on a pour x $0{,}35 \leq x \leq 0{,}45$.

4. LED de conversion selon la revendication 1, **caractérisée en ce que** la stoechiométrie est $Ba_xEu_{1-x}MgAl_{10}O_{17}$, x étant fixé dans la plage x = 0,35 à 0,45.

5. LED de conversion selon la revendication 1, **caractérisée en ce que** la stoechiométrie est $Ba_xEu_{1-x}Mg_{1+d}Al_{10+2f}O_{17+d+3f}$, où l'on a
$0{,}2 \leq x \leq 0{,}48$ ; de préférence $0{,}35 \leq x \leq 0{,}45$ ;

$$0 \leq d \leq 0{,}1 \; ;$$

$$-0{,}1 \leq f \leq 1{,}0.$$

6. LED de conversion selon l'une quelconque des revendications précédentes, destinée à la conversion du rayonnement primaire, la longueur d'onde de crête du rayonnement primaire étant située dans la plage de 300 à 420 nm, de préférence de 340 à 410 nm.

7. LED de conversion selon la revendication 1, **caractérisée en ce que** le matériau fluorescent a la stoechiométrie suivante :

$\{(1-a)*(0{,}82[Ba_xEu_{1-x}O]*6[Al_2O_3])\}*a(Ba_xEu_{1-x}MgAl_{10}O_{17})$, a étant donné par principe par $0 \leq a \leq 1$, notamment a étant au moins 0,2, particulièrement préférée au moins 0,8, la valeur pour x étant située au moins de 0,52 jusqu'à 0,8, et notamment x = 0,55 à 0,65.

8. LED de conversion selon l'une quelconque des revendications précédentes, Mn étant utilisé comme co-dopant.

9. Système d'éclairage comprenant une LED de conversion selon l'une quelconque des revendications précédentes, **caractérisé en ce que** la source de lumière émet un rayonnement primaire ayant une longueur d'onde de crête située dans la plage de 300 à 420 nm, et **en ce qu'**un matériau fluorescent utilisé pour la conversion est un aluminate du type de grille hôte BAM, qui est dopé avec Eu et éventuellement avec Mn en supplément, l'aluminate présentant la stoechiométrie:

$M_xEu_{1-x}Mg_{1-y+d}Mn_yAl_{10+2f}O_{17+d+3f}$, où l'on a
$0{,}2 \leq x \leq 0{,}48$ ; de préférence $0{,}35 \leq x \leq 0{,}45$ ;
$0 \leq y \leq 0{,}3$ ; de préférence $0 \leq y \leq 0{,}2$ ;

$$0 \leq d \leq 0{,}1 \; ;$$

$$-0{,}1 \leq f \leq 1{,}0$$

et où M = Ba est utilisé seul ou est partiellement remplacé par Sr et/ou Ca selon la formule $Ba_z(Ca, Sr)_{1-z}$, avec $z \geq 0{,}7$.

**10.** Système d'éclairage selon la revendication 9, **caractérisé en ce que** la source de lumière est une LED, notamment sur la base de InGaN.

**11.** Système d'éclairage selon la revendication 9, **caractérisé en ce que** la source de lumière est un module d'éclairage comprenant une LED, notamment sur la base de InGaN.

FIG 1

FIG 2

FIG 3

FIG 4

FIG 5

FIG 6

FIG 7

FIG 8

FIG 9

FIG 10

6  4  9  5  7

1

8

2  3

## FIG 11

17

19

15

18

11 16  16

## FIG 12

Figur 13

**EP 2 220 191 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7077978 B
- WO 2006072919 A
- WO 2006027786 A
- WO 2007005486 A2
- US 20060027781 A1
- EP 529956 A